# EUROPEAN PATENT APPLICATION

(11) **EP 4 503 091 A1**
(43) Date of publication of application: **05.02.2025**
(21) Application number: 22935650.6
(22) Date of filing: 16.11.2022
(51) Int. Cl.: H01L 21/02, B32B 27/00, C09J 5/00, C09J 7/38, C09J 7/40, C09J 183/04

(54) **WAFER PRODUCTION METHOD USING PEEL TAPE AND ADHESIVE MATERIAL, PEEL TAPE AND ADHESIVE MATERIAL FOR USE IN SAME**

(30) Priority: 31.03.2022 JP 2022058333
(71) Applicant: Mitsui Chemicals ICT Materia, Inc., Tokyo 104-0028 (JP)
(72) Inventor: SUZUKI Takashi, Sodegaura-shi, Chiba 299-0265 (JP); UNEZAKI Takashi, Sodegaura-shi, Chiba 299-0265 (JP); YASUI Hiroto, Sodegaura-shi, Chiba 299-0265 (JP); TANIMOTO Shuho, Sodegaura-shi, Chiba 299-0265 (JP); KINOSHITA Jin, Nagoya-shi, Aichi 457-0801 (JP)
(74) Representative: J A Kemp LLP
(86) International application number: PCT/JP2022/042564
(87) International publication number: WO 2023/188521

(57) **Abstract**

The present invention addresses the problem of providing a wafer production method that makes it possible to remove an adhesive material from a laminate that comprises a wafer and the adhesive material more simply and stably than conventional methods. The present invention also addresses the problem of providing an adhesive material and a peel tape that make it possible to achieve simpler and more stable removal than conventional adhesive materials and peel tapes.

A wafer production method according to the present invention includes a step for using a peel tape to remove an adhesive material from a laminate A that comprises a wafer and the adhesive material. The peel tape contains a silicone adhesive component in an adhesive layer that is to contact the adhesive material. The adhesive material has a surface A that is to contact the peel tape and a surface B that contacts the wafer, and, when P₁ is the peel strength at surface A as measured keeping the peel tape at 90° to the adhesive material and P₂ is the peel strength at surface B as measured keeping the adhesive material at 90° to the polyimide-coated wafer, the adhesive material has a P₁ and a P₂ that satisfy the following: the peel strength ratio P₁/P₂ is at least 6, and P₂ is at least 0.5 N/25 mm.

## Description

### TECHNICAL FIELD

The present invention relates to a wafer production method, and more specifically, relates to a wafer production method including a step of peeling off an adhesive material temporarily fixing a wafer and a support from the wafer using a peel tape after a wafer treatment such as processing the wafer in a state where the wafer is temporarily fixed to the support.

### BACKGROUND ART

In a semiconductor production process, temporary fixing is often required or preferable in a wafer treatment due to thinness of a wafer and ease of breaking of a wafer. For example, for high integration of a semiconductor device, thin grinding of a wafer on which a functional layer for a semiconductor device is formed is widely performed. However, when grinding is performed to an extreme thinness, it is not possible to support the wafer only with a tape, and thus, it has been proposed to perform a treatment after thin grinding by temporarily fixing the wafer to a hard carrier (support) via an adhesive material. Such a semiconductor production process using a support is referred to as a wafer support system.

In a wafer production process using the wafer support system, it is necessary to peel off the support from the wafer after a thin grinding treatment or the like of the wafer, and then to remove the adhesive material temporarily fixing the wafer and the support from the wafer.

As a method for removing the adhesive material, a method is known in which a peeling tape is attached, and the peeling tape is peeled off to integrally peel off an unnecessary object on a semiconductor wafer (Patent Literature 1). In addition, a method for removing a temporary fixing material with an adhesive sheet (an adhesive tape) that can be simply removed from the wafer, and the adhesive sheet have been proposed (Patent Literature 2 and Patent Literature 3).

Furthermore, an adhesive that can be more simply removed from the wafer has been proposed (Patent Literature 4).

However, even in the case of using the peeling tape or the adhesive tape, or the adhesive, it is not easy to perform peeling from the end of the adhesive material, and a so-called adhesive residue in which a part of the adhesive material remains on the wafer when peeling off the adhesive material may occur, which affects the yield of the wafer.

### CITATION LIST

### PATENT LITERATURE

PATENT LITERATURE 1: JP 2002-124494 A
PATENT LITERATURE 2: JP 2009-275060 A
PATENT LITERATURE 3: JP 2015-518270 A
PATENT LITERATURE 4: WO 2017/221772 A1

### SUMMARY OF INVENTION

### TECHNICAL PROBLEM

In consideration of the technical background described above, an object of the present invention is to provide a wafer production method including a step of peeling off an adhesive material from a laminate A consisting of a wafer and the adhesive material using a peel tape, in which the adhesive material can be peeled off from the laminate A consisting of the wafer and the adhesive material more simply and stably than a conventional peeling method. Another object of the present invention is to provide an adhesive material and a peel tape that can be peeled off more simply and stably than conventional adhesive material and peel tape.

### SOLUTION TO PROBLEM

An adhesive material is used in a wafer treatment method (a wafer support system) for performing a treatment such as grinding in a state where a wafer is temporarily fixed to a support. The adhesive material has surfaces A and B, and is used for processing the wafer by attaching the surface A to the support and attaching the surface B to the wafer side in order to temporarily fix the support and the wafer.

After the processing of the wafer is performed, the support is removed to obtain a laminate A consisting of the wafer and the adhesive material. The present invention relates to a method for removing the adhesive material from the laminate A.

The adhesive material may have an adhesive layer having the surface A and an adhesive layer having the surface B, and may preferably have a peel tape-side adhesive layer, a base film, and a wafer-side adhesive layer. In addition, the adhesive material may be a single-layer adhesive layer obtained by curing a semi-liquid or liquid pressure sensitive adhesive. In this case, the adhesive material may have a peel tape-side adhesive layer and a wafer-side adhesive layer consisting of the same material.

As a result of intensive studies, the present inventors have found that by using a peel tape and an adhesive material in which a ratio of peel strength between the peel tape and the adhesive material and peel strength between the adhesive material and a specific wafer, which is measured in a specific condition, satisfies a specific condition, the adhesive material can be relatively simply and stably peeled off from the laminate A consisting of the wafer and the adhesive material, and have completed the present invention.

That is, the present invention and various aspects thereof are as follows. However, the present invention is not limited to the following.
[1] A wafer production method, comprising
   a step of peeling off an adhesive material from a laminate A consisting of a wafer and the adhesive material using a peel tape,
   the peel tape containing a silicone-based adhesive component in an adhesive layer in contact with the adhesive material, and the adhesive material having P₁ and P₂ satisfying a peel strength ratio P₁/P₂ of 6 or more and P₂ of 0.5 N/25 mm or more being used in the step,
   in which the adhesive material has a surface A in contact with the peel tape and a surface B in contact with the wafer,
   P₁ is peel strength at the surface A when measured by keeping the peel tape at 90° with respect to the adhesive material, and
   P₂ is peel strength at the surface B when measured by keeping the adhesive material at 90° with respect to a polyimide-coated wafer.
[2] The wafer production method according to [1], in which a layer having the surface A of the adhesive material contains a silicone-based adhesive component or a silicone release agent.
[3] The wafer production method according to [1] or [2], in which the adhesive material includes at least a wafer-side adhesive layer, a base film, and a peel tape-side adhesive layer.
[4] A peeling method for peeling off an adhesive material from a laminate A consisting of a wafer and the adhesive material using a peel tape,
   the peel tape containing a silicone-based adhesive component in an adhesive layer in contact with the adhesive material, and the adhesive material having P₁ and P₂ satisfying a peel strength ratio P₁/P₂ of 6 or more and P₂ of 0.5 N/25 mm or more being used,
   in which the adhesive material has a surface A in contact with the peel tape and a surface B in contact with the wafer,
   P₁ is peel strength at the surface A when measured by keeping the peel tape at 90° with respect to the adhesive material, and
   P₂ is peel strength at the surface B when measured by keeping the adhesive material at 90° with respect to a polyimide-coated wafer.
[5] The peeling method according to [4], in which a layer having the surface A of the adhesive material contains a silicone-based adhesive component or a silicone release agent.
[6] The peeling method according to [4] or [5], in which the adhesive material includes at least a wafer-side adhesive layer, a base film, and a peel tape-side adhesive layer.
[7] An adhesive material used in the wafer production method or the peeling method according to [1] to [6], in which P₂ is 0.5 N/25 mm or more.
[8] A peel tape used in the wafer production method or the peeling method according to [1] to [6], in which the peel tape has at least a base film and an adhesive layer, and contains a silicone-based adhesive in the adhesive layer.
[9] The peel tape according to [8], in which the base film of the peel tape includes at least one of polyimide, polyester, or a fluororesin.

### ADVANTAGEOUS EFFECTS OF INVENTION

According to the wafer production method of the present invention, since the adhesive material can be easily and stably removed from the wafer after the wafer is processed by thin grinding or the like, it is possible to perform the peeling with high productivity and yield without causing the adhesive residue and damaging the wafer, which greatly contributes to improvement in the productivity of the electronic component such as an electronic device.

### BRIEF DESCRIPTION OF DRAWINGS

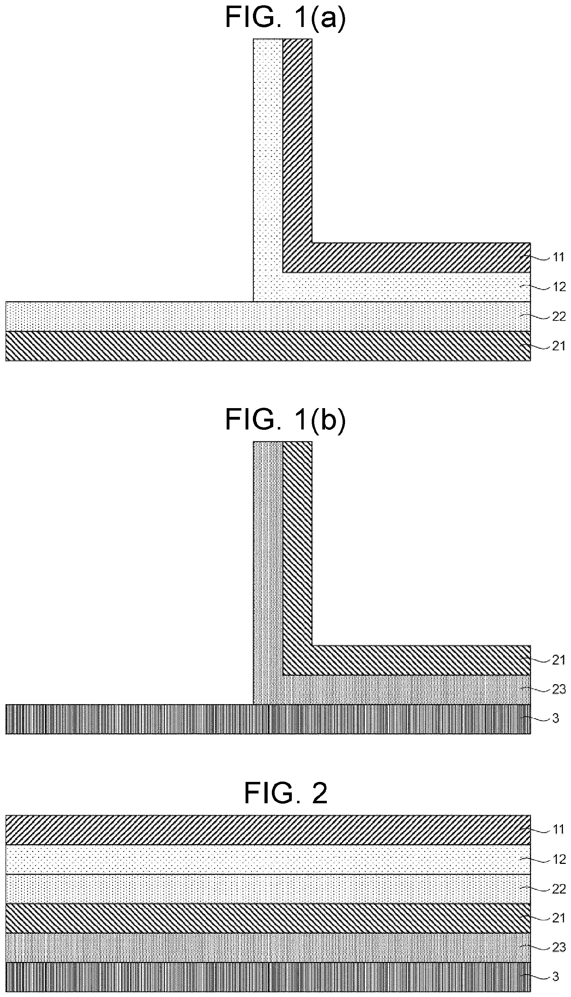

FIG. 1(a) is a schematic view illustrating a method for measuring peel strength P₁ using a sample for measuring the peel strength P₁. Here, a configuration that does not contribute to the peel strength P₁, such as a wafer-side adhesive layer of an adhesive material, is omitted, and there is a portion where a ratio between the dimensions of each member in the drawing does not reflect the actual ratio.
FIG. 1(b) is a schematic view illustrating a method for measuring peel strength P₂ using a sample for measuring the peel strength P₂. Here, a configuration that does not contribute to the peel strength P₂, such as a peel tape-side adhesive layer of the adhesive material, is omitted, and there is a portion where the ratio between the dimensions of each member in the drawing does not reflect the actual ratio.
FIG. 2 is a schematic view illustrating a laminate consisting of a peel tape, an adhesive material, and a wafer when using a double-sided tape in which the adhesive material has a base film. Here, there is a portion where the ratio between the dimensions of each member in the drawing does not reflect the actual ratio.

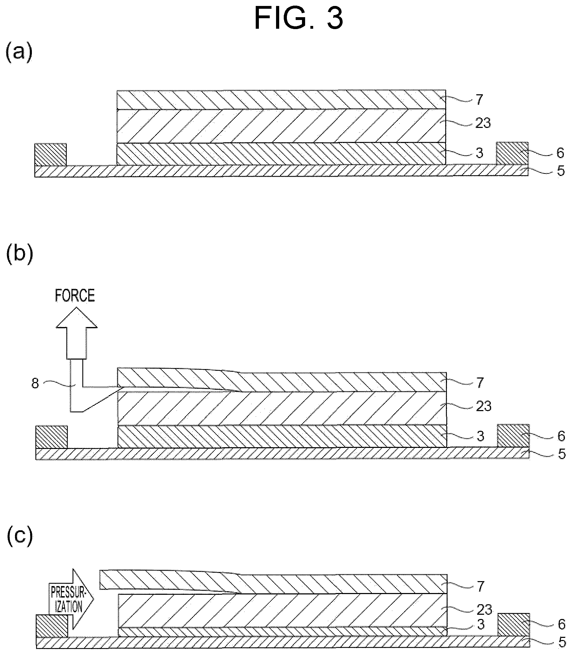

FIG. 3 is a schematic view illustrating a method for removing a support from a laminate B consisting of the support, an adhesive material, and a wafer to prepare a laminate A consisting of the wafer and the adhesive material, in a method for evaluating removability from the wafer. Here, from the viewpoint of simplification, the adhesive material is illustrated as a single-layer structure, and there is a portion where the ratio between the dimensions of each member in the drawing does not reflect the actual ratio.

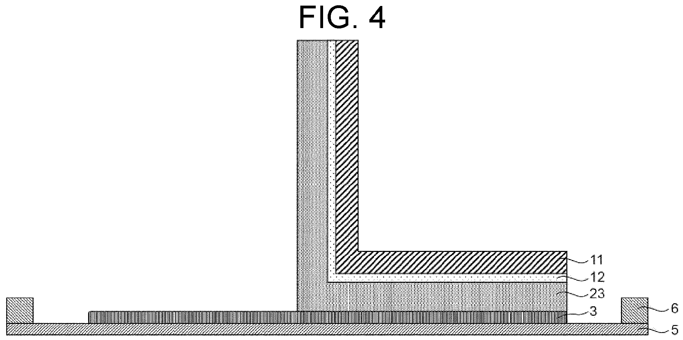

FIG. 4 is a schematic view illustrating the method for evaluating the removability from the wafer. Here, from the viewpoint of simplification, the adhesive material is illustrated as a single-layer structure, and there is a portion where the ratio between the dimensions of each member in the drawing does not reflect the actual ratio.

### DESCRIPTION OF EMBODIMENTS

The present invention is a wafer production method including
a step of peeling off an adhesive material from a laminate A consisting of a wafer and the adhesive material using a peel tape,
the peel tape containing a silicone-based adhesive in an adhesive layer in contact with the adhesive material, and the adhesive material having P₁ and P₂ satisfying a peel strength ratio P₁/P₂ of 6 or more and P₂ of 0.5 N/25 mm or more being used in the step,
in which the adhesive material has a surface A in contact with the peel tape and a surface B in contact with the wafer,
P₁ is peel strength at the surface A when measured by keeping the peel tape at 90° with respect to the adhesive material, and
P₂ is peel strength at the surface B when measured by keeping the adhesive material at 90° with respect to a polyimide-coated wafer.
That is, in the wafer production method of the present invention, the adhesive material and the peel tape are used.

### Adhesive Material

The adhesive material used in the wafer production method of the present invention has P₁ and P₂ satisfying the peel strength ratio P₁/P₂ of 6 or more and P₂ of 0.5 N/25 mm or more. Here, the adhesive material has the surface A in contact with the peel tape and the surface B in contact with the wafer, P₁ is the peel strength at the surface A when measured by keeping the peel tape at 90° with respect to the adhesive material, and P₂ is the peel strength at the surface B when measured by keeping the adhesive material at 90° with respect to the polyimide-coated wafer.

The peel strength P₁ indicates an adhesive force on the surface A (that is, between the peel tape and the adhesive material), and the peel strength P₂ indicates an adhesive force on the surface B (that is, between the adhesive material and the wafer). In the evaluation of the peel strength P₂, the peel strength between the adhesive material and the polyimide-coated wafer is measured by using the polyimide-coated wafer as a wafer for measuring peel strength.

The peel strength P₁ and the peel strength P₂ of the adhesive material used in the present invention are a force (N/mm) per the width of a peeling portion required to advance peeling while keeping an angle between peeled layers (the peel tape and the adhesive material, or the adhesive material and the wafer) at 90°.

That is, for the peel strength P₁ and the peel strength P₂, in the state illustrated in FIG. 1 or in a state similar thereto, the force required for peeling is measured by performing the peeling between the peel tape and the adhesive material or between the adhesive material and the wafer. The peel strength can be determined by dividing the measured value by the width of the peeling portion, and more specifically, can be measured by the following method.

When the peel strength P₁ between the peel tape and the adhesive material is measured, the measurement can be performed using a sample for measuring the peel strength P₁ not having a wafer (FIG. 1(a)).

The sample for measuring the peel strength P₁ is obtained, for example, by fixing a wafer-side adhesive layer of the adhesive material to an acrylic plate (not illustrated) or the like via a double-sided tape. A treatment such as heating may be performed assuming an actual wafer production step before the adhesive material is fixed to the acrylic plate. The adhesive layer 22 of the peel tape is attached to a peel tape-side adhesive layer 22 of the adhesive material of the obtained sample for measuring the peel strength P₁ by a predetermined method, and then the peel tape is peeled off while keeping the angle between the peel tape and the adhesive material at 90°, and thus, the peel strength P₁ can be measured (FIG. 1(a)).

When the peel strength P₂ between the adhesive material and the wafer is measured, the measurement can be performed using a sample for measuring the peel strength P₂ not having a peel tape (FIG. 1(b)).

The sample for measuring the peel strength P₂ is obtained, for example, by attaching a wafer-side adhesive layer 23 of the adhesive material to a polyimide-coated wafer 3 for measurement. In this case, a treatment such as heating may be performed assuming the actual wafer production process. The peel strength P₂ can be measured by peeling off the adhesive material from the obtained sample for measuring the peel strength P₂ while keeping the angle between the adhesive material and the wafer at 90° (FIG. 1(b)).

The peel strength ratio P₁/P₂ is 6 or more, and preferably 6.5 or more.

The peel strength ratio P₁/P₂ has no particular upper limit, but the peel strength ratio P₁/P₂ is preferably 30 or less, more preferably 25 or less, and particularly preferably 20 or less. From the viewpoint of appropriately peeling off the adhesive material from the laminate A consisting of the wafer and the adhesive material, it is desirable that the peel strength P₂ between the adhesive material and the wafer is not excessively large, and from the viewpoint of preventing unintended peeling between the peel tape and the adhesive material and an adhesive residue, it is desirable that the peel strength P₁ between the peel tape and the adhesive material is not excessively small. When the peel strength ratio P₁/P₂ is 6 or more, it is possible to prevent the unintended peeling between the peel tape and the adhesive material and the adhesive residue on the wafer.

The peel strength P₁ is not particularly limited as long as the peel strength ratio P₁/P₂ is satisfied, but is preferably 3 N/25 mm or more. The peel strength P₁ is more preferably 5 N/25 mm or more, and particularly preferably 8 N/25 mm or more. The peel strength P₁ is not particularly limited as long as the peel strength ratio P₁/P₂ is satisfied, but is preferably 60 N/25 mm or less. The peel strength P₁ is more preferably 30 N/25 mm or less, and particularly preferably 20 N/25 mm or less.

When the peel strength P₁ is 3 N/25 mm or more, it is possible to prevent the unintended peeling between the peel tape and the adhesive material and the adhesive residue on the wafer when peeling off the adhesive material from the laminate A consisting of the wafer and the adhesive material.

The peel strength P₂ is 0.5 N/25 mm or more. The peel strength P₂ is preferably 0.7 N/25 mm or more.

The upper limit of the peel strength P₂ is not particularly limited as long as the peel strength ratio P₁/P₂ is satisfied, but is preferably 2.5 N/25 mm or less, and more preferably 2 N/25 mm or less.

Since the peel strength P₂ is 0.5 N/25 mm or more, it is possible to prevent the wafer and the support from being peeled off when performing processing such as a thin grinding treatment of the wafer. When the peel strength P₂ is 2.5 N/25 mm or less, it is possible to prevent the unintended peeling between the peel tape and a temporary fixing material and the adhesive residue on the wafer when peeling off the adhesive material from the wafer.

Means for adjusting the peel strength P₁, the peel strength P₂, and the peel strength ratio P₁/P₂ is not particularly limited, but an appropriate increase or decrease can be made by means conventionally used in the technical field, for example. More specifically, the appropriate increase or decrease can be made by a composition and the production process of each layer described later, the production process of a laminate B consisting of the support, the adhesive material, and the wafer, and the like. For example, the peel strength P₁ and/or the peel strength P₂ can be increased by using a polymer having high polarity in the adhesive material, adding a tackifying resin such as polybutenes, a rosin-based resin, a terpene-based resin, a petroleum-based resin, or a coumarone-based resin, or reducing a crosslinking component. On the other hand, for example, the peel strength P₁ and/or the peel strength P₂ can be reduced by adding a release agent to the adhesive material, increasing the crosslinking component, or using a polymer having low polarity.

The adhesive material used in the wafer production method of the present invention may have a single-layer structure, or may have a laminated structure of a plurality of layers.

When the adhesive material has the single-layer structure, the entire adhesive material may have the same composition, and for example, may be a single-layer tape containing an adhesive component. As the adhesive material, a semi-liquid or liquid curable adhesive may be used as a precursor of the adhesive material. When a semi-liquid or liquid curable adhesive is used, the semi-liquid or liquid adhesive is applied onto either one or both of the support and the wafer, and spin-coated, and then the support and the wafer are bonded to each other via the adhesive, and the adhesive component is cured, and thus, the laminate B consisting of the support, the adhesive material, and the wafer can be produced. After the support is removed from the laminate B, the surface of the adhesive that is in contact with the support becomes the surface A that is in contact with the peel tape.

When the adhesive material has the laminated structure of the plurality of layers, in the adhesive material, a layer having the surface A in contact with the peel tape and a layer having the surface B in contact with the wafer may have different compositions. In this case, the layer having the surface A and the layer having the surface B may have a layered configuration in a general sense in which the composition discontinuously changes at the interface, but may have a so-called gradient composition in which the composition continuously changes.

When the adhesive material has the laminated structure of the plurality of layers, the adhesive material may be a so-called double-sided tape in which both of the layer having the surface A and the layer having the surface B are an adhesive layer. In this case, the layer having the surface A can be configured to have predetermined peel strength between the peel tape and the adhesive material, and the layer having the surface B can be configured to have predetermined peel strength between the adhesive material and the wafer.

Since the layer having the surface A is in contact with the support for temporarily fixing the wafer in a wafer support system, the layer may be configured in consideration of the adhesive force between the adhesive material and the support. For example, in the case of forming the laminate B consisting of the support, the adhesive material, and the wafer by causing adhesion between the support and the wafer using the semi-liquid or liquid adhesive, and then curing the adhesive component, the layer having the surface A of the adhesive material may contain a curable adhesive component.

The adhesive component used in the adhesive layer of the adhesive material includes, for example, components containing a rubber-based adhesive component, an acrylic adhesive component, an epoxy-based adhesive component, a urethane-based adhesive component, an allyl-based adhesive component, a silicone-based adhesive component, a fluorine-based adhesive component, or a polyimide-based adhesive component. The acrylic adhesive component or the silicone-based adhesive component is preferable because such an adhesive component has heat resistance and is easy to adjust the adhesive force. **In** particular, from the viewpoint of adjusting the adhesive force with respect to the peel tape, when the layer having the surface A of the adhesive material is an adhesive layer, the adhesive layer preferably contains an acrylic adhesive component including a silicone release agent.

The adhesive component may be a curable adhesive component or a non-curable adhesive component. Since by curing an adhesive component before a heat treatment, voids are less likely to be generated in the heat treatment during a production step, and adhesion acceleration due to a high temperature during the heat treatment can be suppressed to perform peeling easily without the adhesive residue, the curable adhesive component is preferable.

Examples of the curable adhesive component include a photocurable adhesive component that is crosslinked and cured by light irradiation and a thermosetting adhesive component that is crosslinked and cured by heating.

The photocurable adhesive component and the thermosetting adhesive component include, for example, a photocurable adhesive component and a thermosetting adhesive component containing a monomer, an oligomer, or a polymer such as acryl, epoxy, urethane acrylate, epoxy acrylate, silicone acrylate, or polyester acrylate as a curing component and containing a photopolymerization initiator or a thermal polymerization initiator.

Among them, the polymer of the acrylic adhesive component can be obtained, for example, by synthesizing a (meth)acrylic polymer having a functional group in the molecule (hereinafter, referred to as a functional group-containing (meth)acrylic polymer) to react with a compound having a functional group that reacts with the functional group and a radically polymerizable unsaturated bond in the molecule (hereinafter, referred to as a functional group-containing unsaturated compound).

The functional group-containing (meth)acrylic polymer is obtained by copolymerizing alkyl acrylate and/or alkyl methacrylate having an alkyl group having usually 2 to 18 carbon atoms as a main monomer, a functional group-containing monomer, and as necessary, other modifying monomers copolymerizable with these monomers by a conventional method. The weight average molecular weight of the functional group-containing (meth)acrylic polymer is usually approximately 200000 to 2000000.

The functional group-containing monomer includes, for example, a carboxyl group-containing monomer such as an acrylic acid and a methacrylic acid, a hydroxyl group-containing monomer such as hydroxyethyl acrylate and hydroxyethyl methacrylate, an epoxy group-containing monomer such as glycidyl acrylate and glycidyl methacrylate, an isocyanate group-containing monomer such as isocyanate ethyl acrylate and isocyanate ethyl methacrylate, and an amino group-containing monomer such as aminoethyl acrylate and aminoethyl methacrylate.

The other copolymerizable modifying monomers include, for example, various monomers used for a general (meth)acrylic polymer such as vinyl acetate, acrylonitrile, and styrene.

As the functional group-containing unsaturated compound that reacts with the functional group-containing (meth)acrylic polymer, the same functional group-containing monomer as described above can be used in accordance with the functional group of the functional group-containing (meth)acrylic polymer. For example, when the functional group of the functional group-containing (meth)acrylic polymer is a carboxyl group, an epoxy group-containing monomer or an isocyanate group-containing monomer is used. When the functional group is a hydroxyl group, an isocyanate group-containing monomer is used. When the same functional group is an epoxy group, a carboxyl group-containing monomer or an amide group-containing monomer such as acrylamide is used. When the functional group is an amino group, an epoxy group-containing monomer is used.
the photopolymerization initiator includes, for example, those that are activated by irradiation with light having a wavelength of 250 to 800 nm. Such a photopolymerization initiator includes, for example, photoradical polymerization initiators such as an acetophenone derivative compound such as methoxyacetophenone, a benzoin ether-based compound such as benzoin propyl ether and benzoin isobutyl ether, a ketal derivative compound such as benzyl dimethyl ketal and acetophenone diethyl ketal, a phosphine oxide derivative compound, a bis(η5-cyclopentadienyl) titanocene derivative compound, benzophenone, Michler's ketone, chlorothioxanthone, dodecyl thioxanthone, dimethyl thioxanthone, diethyl thioxanthone, α-hydroxycyclohexyl phenyl ketone, and 2-hydroxymethyl phenyl propane. These photopolymerization initiators may be used alone, or two or more types thereof may be used together.

Examples of the thermal polymerization initiator include those that are decomposed by heat to generate active radicals for initiating polymerization curing. Specifically, the thermal polymerization initiator includes, for example, t-butyl peroxy-2-ethyl hexanoate, bis(4-methyl benzoyl) peroxide, benzoyl peroxide, 1,1-bis(t-hexyl peroxy)cyclohexane, 1,1-bis(t-butyl peroxy)cyclohexane, 2,2-bis(4,4-bis-(t-butyl peroxy)cyclohexyl) propane, t-hexyl peroxyisopropyl monocarboxylate, t-butyl peroxyacetate, 2,2-bis-(t-butyl peroxy)butane, n-butyl-4,4-bis-(t-butyl peroxy)pentanoate, bis-t-hexyl peroxide, dicumyl peroxide, 2,5-dimethyl-2,5-bis(t-butyl peroxy)hexane, bis(2-t-butyl peroxypropyl) benzene, t-butyl cumyl peroxide, di-t-butyl peroxide, 2,5-dimethyl-2,5-bis(t-butyl peroxy)hexyne, diisopropyl benzene hydroperoxide, and the like.

Among these thermal polymerization initiators, a commercially available one is not particularly limited, and for example, PERBUTYL O, NYPER BMT, NYPER BW, PERHEXA HC, PERHEXA C, PERTETRA A, PERHEXYL I, PERBUTYL A, PERHEXA 22, PERHEXA V, PERHEXYL D, PERCUMYL D, PERHEXA 25B, PERBUTYL P, PERBUTYL C, PERHEXYNE 25B, and PERCUMYL P (all manufactured by NOF CORPORATION), Perkadox 12XL25 (manufactured by KAYAKU NOURYON CORPORATION), and the like are suitable. These thermal polymerization initiators may be used alone, or two or more types thereof may be used together.

In general, the oligomer or the monomer as the curable component has 10000 or less of molecular weight, and has 1 to 40 of radically polymerizable unsaturated bonds in the molecule. The number of radically polymerizable unsaturated bonds is preferably 2 or more from the viewpoint of three-dimensional reticulation.

The oligomer or the monomer as the curable component includes, for example, trimethylol propane triacrylate, tetramethylol methane tetraacrylate, pentaerythritol triacrylate, pentaerythritol tetraacrylate, dipentaerythritol monohydroxypentaacrylate, dipentaerythritol hexaacrylate, the equivalent methacrylates to the above, or the like. In addition, other examples include 1,4-butylene glycol diacrylate, 1,6-hexanediol diacrylate, polyethylene glycol diacrylate, commercially available oligoester acrylate, urethane acrylate, the equivalent methacrylates to the above, or the like. These polyfunctional oligomers or monomers may be used alone, or two or more types thereof may be used together.

The adhesive material may contain, as desired, known additives such as various thermal crosslinking agents such as an acrylic polymer having no unsaturated double bond, an isocyanate compound, a melamine compound, and an epoxy compound, a release agent, a plasticizer, a resin, a surfactant, a wax, and a fine particle filler.

**In** the adhesive material, it is preferable that a release agent can be used from the viewpoint of adjusting the peel strength between the peel tape and the adhesive material and/or between the adhesive material and the wafer.

The release agent is not particularly limited as long as a release effect is generally exhibited. The release agent includes, for example, a hydrocarbon-based compound, a silicone-based compound, a fluorine-based compound, and a polyethylene-based wax, a carnauba wax, a montanic acid, and a stearic acid, which are known as a release agent for a plastic material.

**In** addition, a plasticizer is included as the other release agent. The plasticizer is not particularly limited as long as the adhesive force of the adhesive material to an adherend is generally reduced. For examples, the plasticizer includes trimellitate, pyromellitate, phthalate, and adipate.

The release agent is preferably a silicone-based compound or a fluorine-based compound, and more preferably a silicone-based compound or a fluorine-based compound having a functional group crosslinkable with the curable adhesive.

**In** particular, since the silicone compound contained in the silicone release agent is excellent in heat resistance, the silicone compound prevents the scorching and the like of the adhesive material even after a treatment involving heating at 200°C or higher, and when performing peeling, the silicone compound bleeds out to the interface of the adherend to facilitate the peeling. Since the silicone compound has a functional group crosslinkable with the curable adhesive, the silicone compound chemically reacts with the curable adhesive by light irradiation or heating and is incorporated into the curable adhesive, so that the silicone compound does not adhere to the adherend and cause contamination. **In** addition, by blending the silicone compound, an effect of preventing the adhesive residue onto a semiconductor chip is also exhibited.

**In** one aspect of the present invention, the layer having the surface A of the adhesive material may contain a silicone release agent.

The additive amount of the release agent is not particularly limited, but the additive amount is appropriately determined so as to obtain a release effect. On the other hand, the additive amount is controlled such that the additive amount is not excessive so as not to significantly impair the adhesion function of the adhesive material. For example, with respect to 100 parts by mass of the total amount of the adhesive material, it is desirable to adjust the additive amount to usually 0.1 to 5 parts by mass, preferably 0.1 to 3 parts by mass, and more preferably approximately 0.1 to 1 parts by mass, as a guide, in accordance with a peel force.

In addition, in the case of adding the plasticizer, it is desirable to adjust the additive amount to usually 5 to 50 parts by mass, preferably 10 to 50 parts by mass, and more preferably 20 to 40 parts by mass, as a guide, in accordance with the peel force.

In this aspect, these release agents can be used alone or in combination.

In one embodiment, the layer having the surface A of the adhesive material may contain a silicone-based adhesive component or a silicone release agent. When the layer having the surface A contains the silicone-based adhesive component or the silicone release agent, since the peel tape adheres to the end of the adhesive material, which makes it easier to create a trigger when the adhesive material is peeled off from the wafer, the adhesive material can be more easily peeled off from the laminate A consisting of the wafer and the adhesive material.

The thickness of the adhesive material is not particularly limited, but a preferable lower limit is 5 µm and a preferable upper limit is 250 µm, and a more preferable lower limit is 10 µm and a more preferable upper limit is 200 µm. When the thickness of the adhesive material is within such a range, the irregularities of the wafer are absorbed, and thus, the wafer can be temporarily fixed to the support with sufficient strength, and the peel force is easily adjusted to a suitable range even when the adhesive material is peeled off.

In one embodiment, the adhesive material used in the wafer production method of the present invention is preferably a so-called double-sided adhesive tape having a base film between the peel tape-side adhesive layer and the wafer-side adhesive layer. In this aspect, the peel tape-side adhesive layer and the wafer-side adhesive layer can be designed from the viewpoint of optimizing the peel strength between the peel tape and the adhesive material and/or between the adhesive material and the wafer. The base film can be designed from the viewpoint of mechanical strength, handling property, and the like of the adhesive material itself or the laminate B consisting of the support, the adhesive material, and the wafer when the support and the wafer are temporarily fixed, and thus, is particularly advantageous from the viewpoint of optimizing the performance of the adhesive material.

FIG. 2 illustrates an example of a laminate consisting of the peel tape, the adhesive material, and the wafer when a double-sided tape having a base film is used between the wafer-side adhesive layer and the peel tape-side adhesive layer. In the drawing, a reference numeral 11 represents the base film of the peel tape, a reference numeral 12 represents the adhesive layer of the peel tape, a reference numeral 22 represents a peel tape-side adhesive layer of the adhesive material, a reference numeral 21 represents the base film of the adhesive material, a reference numeral 23 represents the wafer-side adhesive layer of the adhesive material, and a reference numeral 3 represents the wafer.

The material of the base film of the adhesive material is not particularly limited, but it is preferable to use a plastic film, and examples thereof include a film or a sheet such as acryl, olefin, polycarbonate, vinyl chloride, ABS, polyethylene terephthalate (PET), polyethylene naphthalate (PEN), nylon, urethane, polyether ether ketone (PEEK), a liquid crystal polymer (LCP), polyimide, polyester, and a fluororesin, a sheet having a mesh structure, a perforated sheet, and the like. From the viewpoint of handling and the like, PET, PEN, or a polyimide film is preferable.

### Peel Tape

The peel tape is used to peel off the adhesive material from the laminate A consisting of the wafer and the adhesive material. The peel tape used in the wafer production method of the present invention includes at least the base film and the adhesive layer, and the adhesive layer contains a silicone-based adhesive component.

Examples of the silicone-based adhesive component include polyorganosiloxane. Examples of the silicone-based adhesive include a peroxide-curable adhesive obtained by adding a silicone resin and an organic peroxide to polyorganosiloxane, or an addition-curable adhesive obtained by mixing vinyl group-containing polyorganosiloxane, a silicone resin, and SiH-containing siloxane.

Since the silicone-based adhesive has a wet-spreading property without depending on the adherend, the peel tape contains the silicone-based adhesive component in the adhesive layer, so that when the peel tape is attached to the adhesive material of the laminate A consisting of the wafer and the adhesive material, the peel tape can be sufficiently attached to the end of the adhesive material. Since it is possible to easily peel off the peel tape from the end of the adhesive material by sufficiently adhering to the end of the adhesive material, it is easier to create a trigger for peeling compared to the conventional technology, and it is possible to stably peel off the adhesive material from the laminate A consisting of the wafer and the adhesive material.

In addition, as the adhesive layer of the peel tape, various adhesive components and additives can be used in addition to the silicone-based adhesive component from the viewpoint of adjusting the peel strength P₁.

The material used in the base film of the peel tape is not particularly limited, but it is preferable to use a plastic film. The base film of the peel tape includes, for example, a film or a sheet such as acryl, olefin, polycarbonate, vinyl chloride, ABS, polyethylene terephthalate (PET), polyethylene naphthalate (PEN), nylon, urethane, polyether ether ketone (PEEK), a liquid crystal polymer (LCP), polyimide, polyester, and a fluororesin, a sheet having a mesh structure, a perforated sheet, and the like. From the viewpoint of handling and adjusting the peel strength P₁, the base film of the peel tape may preferably contain at least one of polyimide, polyester, or a fluororesin.

In the wafer production method of the present invention, the adhesive material can be peeled off from the laminate A consisting of the adhesive material and the wafer by using the peel tape. A method for peeling off the adhesive material is not particularly limited, but for example, the peel tape can be uniformly attached to the surface A of the adhesive material in the laminate A consisting of the adhesive material and the wafer, and one end of the peel tape can be peeled off in a direction of 10° to 180° with respect to the surface B. Since the peel tape can be sufficiently attached to the end of the adhesive material, the adhesive material can be peeled off from the end. In addition, the adhesive material may be further peeled off by mechanical peeling or the like with the end of the adhesive material peeled off from the wafer as a trigger.

### Wafer

In the wafer support system, the wafer is temporarily fixed to the support using the adhesive material, and processing such as back surface grinding of the wafer can be performed as the laminate B consisting of the support, the adhesive material, and the wafer. After the processing of the wafer is performed, the support is removed to obtain a laminate A consisting of the wafer and the adhesive material. Since the wafer production method of the present invention includes the step of peeling off the adhesive material from the laminate A consisting of the wafer and the adhesive material using the peel tape, the wafer is not particularly limited, and any wafer generally used in a semiconductor production process or the like can be produced. Among them, a wafer, which requires careful handling in the treatment from reasons such as thinness and ease to break, and thus, requires temporary fixing, is preferable. Here, regarding the thinness and the ease to break of the wafer, for example, a case is assumed in which the thickness is temporarily reduced in the middle of the treatment and handling is hindered, and the adhesive material is used for temporarily fixing such a wafer to the support. Examples of the case where the thickness of the wafer is temporarily reduced include a case where processing is performed with a thin wafer as a starting point, a case where a thick wafer is thinned in the middle of the process, and a case where processing is further performed with a thinned wafer. The thickness of the temporarily thinned wafer is usually 1 to 200 µm.

For example, in a case where a semiconductor wafer on which the processing of a functional layer is completed is temporarily fixed to the support such that the functional layer is on the support side, the opposite side surface (the back surface) of the functional layer is supplied to steps of thinly grounding, ion implantation, annealing, and electrode formation, and the semiconductor wafer is separated from the support, the semiconductor wafer in the steps corresponds to the wafer.

The wafer treated or produced by the production method of the present invention, as described above, includes a wafer of which the state is changed in the process.

The wafer treated and produced using the wafer production method of the present invention as described above is not particularly limited, and more specific examples thereof include, as semiconductor wafer, a silicon wafer, a compound semiconductor wafer such as SiC, AlSb, AlAs, AlN, AlP, BN, BP, BAs, GaSb, GaAs, GaN, GaP, InSb, InAs, InN, or InP, a crystal wafer, sapphire, glass, a mold wafer, and the like.

The silicon wafer or the compound semiconductor wafer may be doped.

An electrical/electronic functional layer may be formed on or in the wafer. Examples of a suitable functional layer include an electronic circuit, a capacitor, a transistor, a resistor, an electrode, an optical element, MEMS, and the like, but a microdevice other than these may be used.

The surface of these functional layers may have a structure, typically an electrode, formed from one or more of the following materials. The material of the functional layer includes silicon, polysilicon, silicon dioxide, silicon (oxy)nitride, a metal (for example, copper, aluminum, gold, tungsten, and tantalum), a low-k dielectric, a polymer dielectric, various metal nitrides and metal silicides. The surface of the wafer on which the functional layer is formed (the functional layer surface) may have a raised structure such as the bulge of solder, a metal post, and a pillar.

In addition, the wafer surface may be covered with an oxide film or a nitride film for forming a functional layer or protecting the functional layer. In addition, the wafer surface may be covered with a passivation film for wafer protection.

The wafer produced by the wafer production method of the present invention can be further provided to the subsequent steps to produce a final product. In a case where the functional layer is formed on the wafer, steps such as dicing, bonding, packaging, and sealing, which are usually used for producing an electronic device such as a semiconductor device, can be performed to produce the final product.

In the measurement of the peel strength P₂ of the present invention, the polyimide-coated wafer is used as the wafer for measurement as described above. The adhesive force between the adhesive material and the wafer can be changed in accordance with the presence or absence of the functional layer or film on the surface of the wafer, but in a case where the peel strength P₂ using the polyimide-coated wafer as the wafer for measurement is within a predetermined range, the adhesive material can be appropriately peeled off without significantly affecting the peel strength ratio P₁/P₂ even in various wafers generally used in the wafer production process.

### Laminate A

According to the wafer production method of the present invention, the adhesive material can be peeled off from the laminate A consisting of the adhesive material and the wafer to obtain the wafer. The laminate A consisting of the adhesive material and the wafer is obtained, for example, by fixing the support to the surface A of the adhesive material and fixing the wafer to the surface B to obtain the laminate B consisting of the support, the adhesive material, and the wafer, and then removing the support. The laminate B consisting of the support, the adhesive material, and the wafer has sufficient strength and rigidity, and is capable of providing the wafer to various semiconductor production processes while preventing curvature and damage.

As a method for forming the laminate B consisting of the support, the adhesive material, and the wafer, the support, the adhesive material, and the wafer can be laminated in this order. The order of lamination is not particularly limited, and these layers may be laminated at a time or may be sequentially laminated.

When the adhesive material is supplied as a liquid curable adhesive material or the like, the liquid curable adhesive material or the like can be applied onto any one or both of the wafer and the support by spin coating or the like to form the adhesive material or a precursor of the adhesive material, and then, to produce the laminate.

When the adhesive material or the precursor of the adhesive material is supplied as a solid film, since adhesive strength to the support is usually set to be lower than that on the wafer side, from the viewpoint of preventing peeling during handling, it is preferable to first bond the film onto the wafer and then further laminate the support.

In addition, when the film is attached under normal pressure and only the formation of the laminate is performed while the pressure is reduced, from the viewpoint of improving the absorbability of the irregularities of the wafer, it is preferable to first attach the film onto the support and then further bond the film onto the wafer.

When the adhesive material or the precursor of the adhesive material contains the curable adhesive component, the adhesive material may be used by crosslinking and curing the curable adhesive component in the formation of the laminate with light irradiation or heating.

The chemical resistance of the curable adhesive component crosslinked and cured by light irradiation or heating is dramatically improved. Therefore, even when, for example, the back surface of the wafer is subjected to a chemical treatment in a wafer treatment step, it is possible to suppress the adhesive material from being eluted in a chemical. In addition, since the elastic modulus of the crosslinked and cured curable adhesive component increases, the adhesion acceleration hardly occurs even at a high temperature, and peeling is relatively easily performed.

As described above, in this embodiment, although the wafer is subjected to the heat treatment, the machining processing, and/or a wet treatment in the wafer treatment step, a sufficient adhesive force can be maintained when treating the wafer, and the wafer can be peeled off from the adhesive material without being damaged or causing the adhesive residue in a step of removing the support from the laminate B and further peeling off the wafer from the laminate A after the completion of the wafer treatment step.

For example, when an adhesive component containing a polymer having an unsaturated double bond such as a vinyl group on a side chain and a photopolymerization initiator that is activated at a wavelength of 250 to 800 nm is used as a photocurable adhesive component that is crosslinked and cured by the light irradiation, such a photocurable adhesive component is preferably irradiated at an illuminance of 5 mW or more, more preferably at an illuminance of 10 mW or more, even more preferably at an illuminance of 20 mW or more, and particularly preferably at an illuminance of 50 mW or more. Further, the irradiation is performed at an integrated illuminance of preferably 300 mJ or more, more preferably 500 mJ or more and 10000 mJ or less, even more preferably 500 mJ or more and 7500 mJ or less, and particularly preferably 1000 mJ or more and 5000 mJ or less.

In addition, for example, in the case of using an adhesive material containing a polymer having an unsaturated double bond such as a vinyl group on a side chain and a thermal polymerization initiator that is activated by heating at approximately 50 to 200°C as a thermosetting adhesive component in which an adhesive material or a precursor of the adhesive material is crosslinked and cured by the heating, the thermosetting adhesive component can be crosslinked and cured by heating at a temperature of approximately 50 to 200°C for 10 to 60 minutes.

When the precursor of the adhesive material is cured to form the adhesive material as described above, the precursor may be laminated with the support or the wafer after being cured, may be cured after being laminated, or may be finally cured after being laminated in a semicured state.

A method for removing the support from the laminate B consisting of the support, the adhesive material, and the wafer is not particularly limited, but it is preferable to remove the support by mechanical peeling from the viewpoint of a cost and convenience. A method for performing the mechanical peeling is also not particularly limited, and the peeling can be performed using a commercially available apparatus or the like as appropriate.

### Support

In the wafer production method of the present invention, before the step of peeling the adhesive material from the laminate A consisting of the wafer and the adhesive material, the wafer and the support can be temporarily fixed using the adhesive material, and a treatment step such as back surface grinding of the wafer can be performed. The support preferably has sufficient strength and rigidity, and is excellent in heat resistance and chemical resistance. By using such a support, it is possible to stably handle the wafer even when the wafer is thinly ground, and it is possible to provide the wafer to a large number of and/or a wide variety of processes without causing curvature or the like. For example, a wafer on which an electronic circuit is formed can be provided for various processes required for producing an electronic device having a structure in which a semiconductor chips such as TSV connection are stacked.

Examples of the material preferably used for the support include silicon, sapphire, quartz, a metal (for example, aluminum, copper, and steel), and various glasses and ceramics. The support may be composed of a single material, and may be composed of a plurality of materials, or may include other materials deposited on the base. The support may have, for example, a deposited layer of silicon nitride or the like on a silicon wafer. The support may be subjected to a surface treatment such as providing a silicone layer.

Depending on the temperature of the process to which the laminate is provided, the support may be composed of plastic. For example, a sheet consisting of plastic such as polyimide, acryl, polyolefin, polycarbonate, vinyl chloride, ABS, polyethylene terephthalate (PET), nylon, or urethane can be preferably used as the support. Since polyimide has a certain degree of heat resistance, the polyimide can be used.

In order to obtain uniformity in the thickness of the wafer after grinding or the like, the thickness of the support is desirably uniform. For example, in order to decrease the thickness of the silicon wafer to 50 µm or less and make the uniformity thereof ±10% or less, a variation in the thickness of the support is to be suppressed to ±2 µm or less.

The thickness of the support is not particularly limited, but is preferably 300 µm or more, and particularly preferably 500 µm or more, from the viewpoint of effectively preventing the curvature of the wafer. The thickness is preferably 1500 µm or less, and particularly preferably 1000 µm or less, from the viewpoint of suppressing the total weight during handling, reducing a stress required for mechanical peeling, or the like.

In addition, the present invention provides not only the wafer production method but also a peeling method for peeling off an adhesive material from a laminate A consisting of a wafer and the adhesive material using a peel tape, the peel tape containing a silicone-based adhesive component in an adhesive layer in contact with the adhesive material, and the adhesive material having P₁ and P₂ satisfying a peel strength ratio P₁/P₂ of 6 or more and P₂ of 0.5 N/25 mm or more being used, in which the adhesive material has a surface A in contact with the peel tape and a surface B in contact with the wafer, P₁ is peel strength at the surface A when measured by keeping the peel tape at 90° with respect to the adhesive material, and P₂ is peel strength at the surface B when measured by keeping the adhesive material at 90° with respect to a polyimide-coated wafer.

The peeling method of the present invention is not limited to the wafer production step, and for example, in the case of protecting the wafer using the adhesive material during handling such as transportation of the thinned wafer, the adhesive material used for protection can be stably peeled off from the laminate A consisting of the wafer and the adhesive material. In this aspect, the adhesive material may be in the form of a protective tape having an adhesive layer.

The measurement condition of each peel strength between the peel tape and the adhesive material and between the adhesive material and the wafer used in the peeling method of the present invention are as described above. The peel tape contains a silicone-based adhesive component in the adhesive layer from the viewpoint of being in contact with the adhesive material on the surface A.

The adhesive material used in the peeling method of the present invention is not particularly limited as long as the above condition is satisfied, but preferably, the layer having the surface A of the adhesive material contains a silicone-based adhesive component or a silicone release agent.

Since the silicone compound contained in the silicone release agent is excellent in heat resistance, the silicone compound prevents the scorching and the like of the adhesive material even after a treatment involving heating at 200°C or higher, and when performing peeling, the silicone compound bleeds out to the interface of the adherend to facilitate the peeling. In addition, since the silicone compound has a functional group crosslinkable with the curable adhesive that can be contained as the adhesive component, the silicone compound chemically reacts with the curable adhesive by light irradiation or heating and is incorporated into the curable adhesive, so that the silicone compound does not adhere to the adherend and cause contamination. Furthermore, by blending the silicone compound, an effect of preventing the adhesive residue onto the wafer is also exhibited.

In particular, when the layer having the surface A of the adhesive material is an adhesive layer, the adhesive layer preferably contains a silicone release agent from the viewpoint of adjusting the adhesive force with respect to the peel tape. Particularly preferably, the adhesive layer preferably contains an acrylic adhesive component containing a silicone release agent. The silicone release agent easily adjusts the adhesive force while maintaining the heat resistance.

The adhesive material used in the peeling method of the present invention preferably has at least a wafer-side adhesive layer, a base film, and a peel tape-side adhesive layer. As the adhesive component used in the wafer-side adhesive layer and the peel tape-side adhesive layer, the adhesive components described above can be used. As the base film, the base films described above can also be used.

The present invention provides an adhesive material used in the wafer production method or the peeling method described above, in which peel strength P₂ is 0.5 N/25 mm or more. Here, the measurement condition of the peel strength P₂ and the configuration of the adhesive material are as described above.

The adhesive material of the present invention has the peel strength P₂ of 0.5 N/25 mm or more. The peel strength P₂ is preferably 0.7 N/25 mm or more.

The upper limit of the peel strength P₂ is not particularly limited as long as the peel strength ratio P₁/P₂ is satisfied, but is preferably 2.5 N/25 mm or less, and more preferably 2 N/25 mm or less.

Since the peel strength P₂ is 0.5 N/25 mm or more, it is possible to prevent the wafer and the support from being peeled off when performing processing such as a thin grinding treatment of the wafer. When the peel strength P₂ is 2 N/25 mm or less, it is possible to prevent the unintended peeling between the peel tape and the adhesive material and the adhesive residue on the wafer when peeling off the adhesive material from the wafer.

In the adhesive material of the present invention, from the viewpoint of adjusting the peel strength P₁ between the peel tape and the adhesive material, the layer of the adhesive material having the surface A in contact with the peel tape may contain a silicone-based adhesive component or a silicone release agent. When the layer having the surface A contains the silicone-based adhesive component or the silicone release agent, since the peel tape adheres to the end of the adhesive material, which makes it easier to create a trigger when the adhesive material is peeled off from the wafer, the adhesive material can be more easily peeled off from the laminate A consisting of the wafer and the adhesive material. The silicone-based adhesive component and the silicone release agent that can be used in the adhesive material of the present invention are as described above.

Furthermore, the present invention provides a peel tape used in the wafer production method or the peeling method described above, in which the peel tape has at least a base film and an adhesive layer, and contains a silicone-based adhesive in the adhesive layer.

The adhesive layer of the peel tape of the present invention contains a silicone-based adhesive component.

Examples of the silicone-based adhesive component include polyorganosiloxane. Examples of the silicone-based adhesive include a peroxide-curable adhesive obtained by adding a silicone resin and an organic peroxide to polyorganosiloxane, or an addition-curable adhesive obtained by mixing vinyl group-containing polyorganosiloxane, a silicone resin, and SiH-containing siloxane. Since the silicone-based adhesive has a wet-spreading property without depending on the adherend, the peel tape contains the silicone-based adhesive component in the adhesive layer, so that the peel tape can be sufficiently attached to the end of the adhesive material. Therefore, it is possible to easily peel off the peel tape from the end of the adhesive material by sufficiently adhering to the end of the adhesive material.

In addition, the material used in the base film of the peel tape is not particularly limited, and the materials described above can be used. From the viewpoint of handling and adjusting the peel strength P₁, the base film of the peel tape preferably contains at least one of polyimide, polyester, or a fluororesin.

### EXAMPLES

Hereinafter, the present invention will be specifically described. It is note that the present invention is not limited by the following Examples in any sense.

The physical properties and characteristics in Examples and Comparative Examples were evaluated by the following methods.

### (1) Evaluation of Removability of Adhesive Material from Wafer

### (1-1) Preparation of Laminate A

By using a silicon wafer as a support 7 and a polyimide-coated wafer as the wafer 3, the laminate B in which the support 7, the adhesive material 23 (illustrated as a single-layer structure for simplification), and the wafer 3 were laminated in this order was prepared, and a heat treatment was performed on the laminate B at 140°C for 30 minutes and then at 200°C for 30 minutes, and then the laminate B was fixed on a dicing tape 5 attached to a ring frame 6 at room temperature with the polyimide-coated wafer side facing down, and the dicing tape 5 was fixed by vacuum chucking (FIG. 3(a)). In order to perform peeling at the interface between a silicon wafer as the support 7 and the adhesive material 23, a remover 8 was slid into the interface between the support 7 and the adhesive material 23, and an upward force of typically approximately 120 N was applied to the end of the silicon wafer as the support to form a peeling interface that triggers the peeling between the support 7 and the adhesive material 23 (FIG. 3(b)).

Subsequently, the pressure was applied to the formed peeling interface (FIG. 3(c)), and the silicon wafer as the support 7 was peeled off by expanding the peeling interface to prepare the laminate A consisting of the wafer and the adhesive material.

### (1-2) Evaluation

For the laminate A consisting of the wafer 3 and the adhesive material 23 (illustrated as a single-layer structure for simplification) fixed to the dicing tape 5 attached to the ring frame 6, the peel tape consisting of the base film 11 of the peel tape and the adhesive layer 12 of the peel tape was attached to the entire surface of the adhesive material 23. The dicing tape 5 was fixed with a vacuum chuck, and the peel tape consisting of 11 and 12 was lifted at a peel angle of 90° and a peel rate of 5 mm/s to peel off the adhesive material 23. The peelability was evaluated in accordance with the following criteria (FIG. 4).
○: It was possible to completely peel off the adhesive material from the wafer, and no damage occurred in the wafer.
×: It was not possible to peel off the adhesive material from the wafer.

### (2) Measurement of Peel Strength P₁ (Peel Strength at Surface A between Peel Tape and Adhesive Material)

### (2-1) Preparation of Sample for Measuring P₁

An adhesive material 1 or an adhesive material 2 described later was cut into 3 cm × 5 cm, and attached to a silicon wafer as a support such that peel tape-side adhesive layers faced each other. A polyethylene terephthalate film (a separator) subjected to a silicone release treatment was attached to a wafer-side adhesive layer (a laminate C). The laminate C was heated at 140°C for 30 minutes, and then heated at 200°C for 30 minutes as a condition assuming a pretreatment in a step of forming the laminate A. Thereafter, the separator and the silicon wafer were removed to obtain a sample for measuring P₁.

### (2-2) Measurement

The wafer-side adhesive layer of the sample for measuring P₁ prepared in (2-1) was attached to an acrylic plate (not illustrated) via a commercially available double-sided tape. The adhesive layer 12 of the peel tape cut into 3 cm × 6 cm was attached to the peel tape-side adhesive layer 22 of the sample for measuring P₁, and the peel tape was cut into a width of 2.5 cm for each sample for measuring P₁. Thereafter, pressurization was performed with one reciprocation by a 2 kg roller. The peel strength P₁ was measured at a tensile rate of 300 mm/min and a peel angle of 90° using VPA-S (manufactured by Kyowa Interface Science Co., Ltd.) at 22.5±1°C and relative humidity of 50±10% (FIG. 1(a)).

### (3) Measurement of Peel Strength P₂ (Peel Strength at Surface B between Adhesive Material and Wafer)

### (3-1) Preparation of Sample for Measuring P₂

An adhesive material 1 or an adhesive material 2 described later was cut into 3 cm × 5 cm, attached to a polyimide-coated wafer such that wafer-side adhesive layers faced each other, and then pressurized with one reciprocation by a 2 kg roller. A polyethylene terephthalate film (a separator) subjected to a silicone release treatment was attached to a peel tape-side adhesive layer (a laminate D). The laminate D was heated at 140°C for 30 minutes, and then heated at 200°C for 30 minutes as a condition assuming a pretreatment in the step of forming the laminate A. Thereafter, the separator on the peel tape-side adhesive layer was removed to obtain a sample for measuring P₂.

### (3-2) Measurement

The sample for measuring P₂ prepared in (3-1) was cut into 2.5 cm × 5 cm, and the peel strength P₂ was measured at a tensile rate of 300 mm/min and a peel angle of 90 degrees using VPA-S (manufactured by Kyowa Interface Science Co., Ltd.) at 22.5±1°C and relative humidity of 50±10% (FIG. 1(b)).

The details of the materials used in Examples and Comparative Examples are as follows.

### Support and Wafer

In the check of the removability of the adhesive material, the following silicon wafer and polyimide-coated wafer were used as the support and the wafer.
· Silicon Wafer

A Si mirror wafer having Outer Diameter of 150 mm × Thickness of 625 µm was used.
· Polyimide-Coated Wafer

A wafer in which a polyimide film of 5 µm was provided on a Si mirror wafer having Outer Diameter of 150 mm × Thickness of 625 µm was used.

### Wafer for Measuring Peel Strength P₂

For the measurement of the peel strength P₂, the following wafers were used.

### · Polyimide-Coated Wafer

A wafer in which a polyimide film of 5 µm was provided on a Si mirror wafer having Outer Diameter of 150 mm × Thickness of 625 µm was used.

### Peel Tape

In Examples and Comparative Examples, the following peel tapes were used.
· Peel Tape 1: No. 360UL (manufactured by Nitto Denko Corporation)
· Peel Tape 2: 5413 (manufactured by 3M Japan Limited)
· Peel Tape 3: 8992 (manufactured by 3M Japan Limited)
· Peel Tape 4: MHM-SI25 (manufactured by NEION Film Coatings Corp.) was lined with a PET film 50 µm.
· Peel Tape 5: ASF116T FR (manufactured by Chukoh Chemical Industries, Ltd.)
· Peel Tape 6: No. 31B (manufactured by Nitto Denko Corporation)
· Peel Tape 7: VHB BR-12 (manufactured by 3M Japan Limited) was lined with a PET film of 50 µm.
· Peel Tape 8: Sellotape (Registered Trademark) (manufactured by Nichiban Co., Ltd.)

### Resin for Forming Adhesive Layer

A resin used for forming the adhesive layer of the adhesive material was prepared as follows.

### · (Meth)Acrylic Resin Solution N

49 parts by mass of ethyl acrylate, 20 parts by mass of 2-ethyl hexyl acrylate, 21 parts by mass of methyl acrylate, 10 parts by mass of glycidyl methacrylate, and 0.5 parts by mass of a benzoyl peroxide-based polymerization initiator as a polymerization initiator were reacted in a solvent consisting of 65 parts by mass of toluene and 50 parts by mass of ethyl acetate at 80°C for 10 hours. After the completion of the reaction, the obtained solution was cooled, 25 parts by mass of xylene, 5 parts by mass of an acrylic acid, and 0.5 parts by mass of tetradecyl dimethyl benzyl ammonium chloride were added to the cooled solution, and a reaction was caused at 85°C for 32 hours while blowing the air to obtain a (meth)acrylic resin solution N.

### Base Film

For the base film used in the adhesive material, the following films were used.
· PEN Film

A polyethylene naphthalate film (a double-sided corona treatment, Thickness: 50 µm, manufactured by TOYOBO FILM SOLUTIONS LIMITED, Teonex Q83) was used.
· PET Film

A biaxially stretched polyethylene terephthalate film (a double-sided corona treatment, a thickness of 38 µm, manufactured by Toray Industries, Inc., Lumirror S10) was used.
· Polyimide Film

A polyimide film (a double-sided plasma treatment, a thickness of 38 µm, manufactured by DU PONT-TORAY CO., LTD., product name: Kapton (Registered Trademark) 150EN-A) was used.

### Adhesive Material 1

2.84 parts by mass of HDI isocyanurate (manufactured by TOSOH CORPORATION, product name: CORONATE HX), 50 parts by mass of dipentaerythritol penta/hexaacrylate (manufactured by Toagosei Co., Ltd., product name: ARONIX M-402), 2.0 parts by mass of silicone diacrylate (manufactured by DAICEL-ALLNEX LTD., product name: Ebecryl 350), and 2 parts by mass of Perkadox 12XL25 (manufactured by KAYAKU NOURYON CORPORATION) were added to 270 parts by mass of the (meth)acrylic resin solution N to obtain a coating liquid 1-1 for an adhesive layer on a support side (a peel tape side). The coating liquid 1-1 was applied to the base film (the PEN film) and dried at 100°C for 10 minutes to form an adhesive layer 1-1 having a thickness of 25 µm as the adhesive layer on the support side (the peel tape side). Next, a polyethylene terephthalate film (a separator) subjected to a silicone release treatment was bonded to obtain a laminate consisting of the adhesive layer 1-1 and the base film with the separator.

0.1 parts by mass of HDI isocyanurate (manufactured by TOSOH CORPORATION, product name: CORONATE HX), 30 parts by mass of dipentaerythritol penta/hexaacrylate (manufactured by Toagosei Co., Ltd., product name: ARONIX M-402), 0.5 parts by mass of silicone diacrylate (manufactured by DAICEL-ALLNEX LTD., product name: Ebecryl 350), and 2 parts by mass of Perkadox 12XL25 (manufactured by KAYAKU NOURYON CORPORATION) were added to 270 parts by mass of the (meth)acrylic resin solution N to obtain a coating liquid 1-2 for an adhesive layer on a wafer side. The coating liquid 1-2 was applied to a polyethylene terephthalate film (a separator) subjected to a silicone release treatment, and dried at 100°C for 10 minutes to form an adhesive layer 1-2 having a thickness of 40 µm as the adhesive layer on the wafer side. Next, the adhesive layer 1-2 was bonded to the base side of the laminate consisting of the adhesive layer 1-1 and the base film described above to prepare a laminate composed of three layers of the adhesive layer 1-1, the base film, and the adhesive layer 1-2 with the separator.

5.68 parts by mass of HDI isocyanurate (manufactured by TOSOH CORPORATION, product name: CORONATE HX), 30 parts by mass of dipentaerythritol penta/hexaacrylate (manufactured by Toagosei Co., Ltd., product name: ARONIX M-402), 0.5 parts by mass of silicone diacrylate (manufactured by DAICEL-ALLNEX LTD., product name: Ebecryl 350), and 2 parts by mass of Perkadox 12XL25 (manufactured by KAYAKU NOURYON CORPORATION) were added to 270 parts by mass of the (meth)acrylic resin solution N to obtain a coating liquid 1-3 for the adhesive layer on the wafer side. The coating liquid 1-3 was applied to a polyethylene terephthalate film (a separator) subjected to a silicone release treatment, and dried at 100°C for 10 minutes to form an adhesive layer 1-3 having a thickness of 10 µm as the adhesive layer on the wafer side. Next, the adhesive layer 1-3 was bonded to the adhesive layer 1-2 side of the laminate consisting the three layers of the adhesive layer 1-1, the base film, and the adhesive layer 1-2 with the separator described above to prepare a precursor of the adhesive material 1 before a heat treatment, composed of four layers of the adhesive layer 1-1, the base film, the adhesive layer 1-2, and the adhesive layer 1-3 with the separator.

### Adhesive Material 2

2.84 parts by mass of HDI isocyanurate (manufactured by TOSOH CORPORATION, product name: CORONATE HX), 50 parts by mass of dipentaerythritol penta/hexaacrylate (manufactured by Toagosei Co., Ltd., product name: ARONIX M-402), 2.0 parts by mass of an acrylic group-containing polyether-modified polydimethyl siloxane (manufactured by BYK Japan KK, product name: BYK-UV3500), and 2 parts by mass of Perkadox 12XL25 (manufactured by KAYAKU NOURYON CORPORATION) were added to 270 parts by mass of the (meth)acrylic resin solution N to obtain a coating liquid 2-1 for an adhesive layer on a support side (a peel tape side). The coating liquid 2-1 was applied to the base film (the PEN film) and dried at 100°C for 10 minutes to form an adhesive layer 2-1 having a thickness of 25 µm as the adhesive layer on the support side (the peel tape side). Next, a polyethylene terephthalate film (a separator) subjected to a silicone release treatment was bonded to obtain a laminate consisting of the adhesive layer 2-1 and the base film with the separator.

0.1 parts by mass of HDI isocyanurate (manufactured by TOSOH CORPORATION, product name: CORONATE HX), 30 parts by mass of dipentaerythritol penta/hexaacrylate (manufactured by Toagosei Co., Ltd., product name: ARONIX M-402), and 2 parts by mass of Perkadox 12XL25 (manufactured by KAYAKU NOURYON CORPORATION) were added to 270 parts by mass of the (meth)acrylic resin solution N to obtain a coating liquid 2-2 for an adhesive layer on a wafer side. The coating liquid 2-2 was applied to a polyethylene terephthalate film (a separator) subjected to a silicone release treatment and dried at 100°C for 10 minutes to form an adhesive layer 2-2 having a thickness of 40 µm as the adhesive layer on the wafer side. Next, the adhesive layer 2-2 was bonded to the base side of the laminate consisting of the adhesive layer 2-1 and the base film described above to obtain a laminate having a three-layer configuration of the adhesive layer 2-1, the base film, and the adhesive layer 2-2 with the separator.

5.68 parts by mass of HDI isocyanurate (manufactured by TOSOH CORPORATION, product name: CORONATE HX), 30 parts by mass of dipentaerythritol penta/hexaacrylate (manufactured by Toagosei Co., Ltd., product name: ARONIX M-402), and 2 parts by mass of Perkadox 12XL25 (manufactured by KAYAKU NOURYON CORPORATION) were added to 270 parts by mass of the (meth)acrylic resin solution N to obtain a coating liquid 2-3 for the adhesive layer on the wafer side. The coating liquid 2-3 was applied to a polyethylene terephthalate film (a separator) subjected to a silicone release treatment and dried at 100°C for 10 minutes to form an adhesive layer 2-3 having a thickness of 10 µm as the adhesive layer on the wafer side. Next, the adhesive layer 2-3 was bonded to the adhesive layer 2-2 side of the laminate having the three-layer configuration of the adhesive layer 2-1, the base film, and the adhesive layer 2-2 with the separator described above to prepare a precursor of the adhesive material 2 before a heat treatment, having a four-layer configuration of the adhesive layer 2-1, the base film, the adhesive layer 2-2, and the adhesive layer 2-3 with the separator.

### (Example 1)

By using the adhesive material 1 and a peel tape 1, the peel strengths P₁ and P₂ were measured in accordance with the measurement of the peel strength, and P₁/P₂ was calculated. As a result, P₁/P₂ = 6.6.

In addition, when the removability of the adhesive material 1 from the wafer was examined in accordance with the check of the removability of the adhesive material from the wafer, it was possible to completely peel off the adhesive material 1 from the wafer, and the wafer was not damaged.

### (Example 2)

The peel strengths P₁ and P₂ were measured as with Example 1, except that a peel tape 2 was used. P₁/P₂ = 6.8, it was possible to completely peel off the adhesive material 1 from the wafer, and the wafer was not damaged.

### (Example 3)

The peel strengths P₁ and P₂ were measured as with Example 1, except that a peel tape 3 was used. P₁/P₂ = 7.8, it was possible to completely peel off the adhesive material 1 from the wafer, and the wafer was not damaged.

### (Example 4)

The peel strengths P₁ and P₂ were measured as with Example 1, except that a peel tape 4 was used. P₁/P₂ = 11.9, it was possible to completely peel off the adhesive material 1 from the wafer, and the wafer was not damaged.

### (Example 5)

Peel strengths P₁ and P₂ were measured as with Example 1, except that the adhesive material 2 was used. P₁/P₂ = 9.6, it was possible to completely peel off the adhesive material 2 from the wafer, and the wafer was not damaged.

### (Example 6)

Peel strengths P₁ and P₂ were measured as with Example 2, except that the adhesive material 2 was used. P₁/P₂ = 9.3, it was possible to completely peel off the adhesive material 2 from the wafer, and the wafer was not damaged.

### (Example 7)

Peel strengths P₁ and P₂ were measured as with Example 3, except that the adhesive material 2 was used. P₁/P₂ = 10.7, it was possible to completely peel off the adhesive material 2 from the wafer, and the wafer was not damaged.

### (Example 8)

Peel strengths P₁ and P₂ were measured as with Example 4, except that the adhesive material 2 was used. P₁/P₂ = 16.2, it was possible to completely peel off the adhesive material 2 from the wafer, and the wafer was not damaged.

### (Comparative Example 1)

The peel strengths P₁ and P₂ were measured as with Example 1, except that a peel tape 5 was used. P₁/P₂ = 4.2, and it was not possible to completely peel off the adhesive material 1 from the wafer.

### (Comparative Example 2)

The peel strengths P₁ and P₂ were measured as with Example 1, except that a peel tape 6 was used. P₁/P₂ = 5.0, and it was not possible to completely peel off the adhesive material 1 from the wafer.

### (Comparative Example 3)

The peel strengths P₁ and P₂ were measured as with Example 1, except that a peel tape 7 was used. P₁/P₂ = 10.0, and it was not possible to completely peel off the adhesive material 1 from the wafer.

### (Comparative Example 4)

The peel strengths P₁ and P₂ were measured as with Example 1, except that a peel tape 8 was used. P₁/P₂ = 6.2, and it was not possible to completely peel off the adhesive material 1 from the wafer.

### (Comparative Example 5)

Peel strengths P₁ and P₂ were measured as with Comparative Example 1, except that the adhesive material 2 was used. P₁/P₂ = 5.4, and it was not possible to completely peel off the adhesive material 2 from the wafer.

### (Comparative Example 6)

Peel strengths P₁ and P₂ were measured as with Comparative Example 2, except that the adhesive material 2 was used. P₁/P₂ = 4.3, and it was not possible to completely peel off the adhesive material 2 from the wafer.

### (Comparative Example 7)

Peel strengths P₁ and P₂ were measured as with Comparative Example 3, except that the adhesive material 2 was used. P₁/P₂ = 12.3, and it was not possible to completely peel off the adhesive material 2 from the wafer.

### (Comparative Example 8)

Peel strengths P₁ and P₂ were measured as with Comparative Example 4, except that the adhesive material 2 was used. P₁/P₂ = 7.1, and it was not possible to completely peel off the adhesive material 2 from the wafer.

The combination of the peel tape and the adhesive material used in each of Examples and Comparative Examples, the measurement result of the peel strength, and the evaluation result of the removability of the adhesive material from the wafer are shown in Tables 1 and 2.

### [Table 1]

**Table 1**

| | Peel Tape | | Adhesive Material | Measurement of Peel Strength [N/25mm] | | | Removability from Wafer |
|---|---|---|---|---|---|---|---|
| | Tape Number | Adhesive Type | | P₁[N/25mm] | P₂[N/25mm] | P₁/P₂ | |
| Example 1 | 1 | Silicone-Based | 1 | 8.0 | 1.2 | 6.6 | ○ |
| Example 2 | 2 | Silicone-Based | 1 | 8.2 | 1.2 | 6.8 | ○ |
| Example 3 | 3 | Silicone-Based | 1 | 9.4 | 1.2 | 7.8 | ○ |
| Example 4 | 4 | Silicone-Based | 1 | 14.4 | 1.2 | 11.9 | ○ |
| Comparative Example 1 | 5 | Silicone-Based | 1 | 5.0 | 1.2 | 4.2 | × |
| Comparative Example 2 | 6 | Acrylic | 1 | 6.0 | 1.2 | 5.0 | × |
| Comparative Example 3 | 7 | Acrylic | 1 | 12.0 | 1.2 | 10.0 | × |
| Comparative Example 4 | 8 | Rubber-Based | 1 | 7.4 | 1.2 | 6.2 | × |

### [Table 2]

**Table 2**

| | Peel Tape | | Adhesive Material | Measurement of Peel Strength [N/25mm] | | | Removability from Wafer |
|---|---|---|---|---|---|---|---|
| | Tape Number | Adhesive Type | | P₁[N/25mm] | P₂[N/25mm] | P₁/P₂ | |
| Example 5 | 1 | Silicone-Based | 2 | 9.3 | 0.97 | 9.6 | ○ |
| Example 6 | 2 | Silicone-Based | 2 | 9.1 | 0.97 | 9.3 | ○ |
| Example 7 | 3 | Silicone-Based | 2 | 10.4 | 0.97 | 10.7 | ○ |
| Example 8 | 4 | Silicone-Based | 2 | 15.7 | 0.97 | 16.2 | ○ |
| Comparative Example 5 | 5 | Silicone-Based | 2 | 5.2 | 0.97 | 5.4 | × |
| Comparative Example 6 | 6 | Acrylic | 2 | 4.2 | 0.97 | 4.3 | × |
| Comparative Example 7 | 7 | Acrylic | 2 | 11.9 | 0.97 | 12.3 | × |
| Comparative Example 8 | 8 | Rubber-Based | 2 | 6.8 | 0.97 | 7.1 | × |

### INDUSTRIAL APPLICABILITY

According to the wafer production method using the peel tape and the adhesive material of the present invention, and the peel tape and the adhesive material used in the method, a large number and/or a wide variety of steps can be performed on the wafer with high productivity and yield without damaging the electronic component such as a functional layer formed on the wafer, which greatly contributes to improvement in the productivity of the electronic device, and the wafer production method, the peel tape, and the adhesive material have high applicability in various fields of industries such as an electronic component industry including a semiconductor process industry, an electrical/electronic industry using electronic components, a transport machine industry, an information communication industry, and a precision equipment industry.

### REFERENCE SIGNS LIST

- 11: base film of peel tape
- 12: adhesive layer of peel tape
- 21: base film of adhesive material
- 22: peel tape-side adhesive layer of adhesive material
- 23: wafer-side adhesive layer of adhesive material or adhesive material having single-layer structure
- 3: wafer
- 5: dicing tape
- 6: ring frame
- 7: support
- 8: remover

## Claims

1. A wafer production method, comprising
a step of peeling off an adhesive material from a laminate A consisting of a wafer and the adhesive material using a peel tape,
the peel tape containing a silicone-based adhesive component in an adhesive layer in contact with the adhesive material, and the adhesive material having P₁ and P₂ satisfying a peel strength ratio P₁/P₂ of 6 or more and P₂ of 0.5 N/25 mm or more being used in the step,
wherein the adhesive material has a surface A in contact with the peel tape and a surface B in contact with the wafer,
P₁ is peel strength at the surface A when measured by keeping the peel tape at 90° with respect to the adhesive material, and
P₂ is peel strength at the surface B when measured by keeping the adhesive material at 90° with respect to a polyimide-coated wafer.

2. The wafer production method according to claim 1,
wherein a layer having the surface A of the adhesive material contains a silicone-based adhesive component or a silicone release agent.

3. The wafer production method according to claim 1 or 2,
wherein the adhesive material includes at least a wafer-side adhesive layer, a base film, and a peel tape-side adhesive layer.

4. A peeling method for peeling off an adhesive material from a laminate A consisting of a wafer and the adhesive material using a peel tape,
the peel tape containing a silicone-based adhesive component in an adhesive layer in contact with the adhesive material, and the adhesive material having P₁ and P₂ satisfying a peel strength ratio P₁/P₂ of 6 or more and P₂ of 0.5 N/25 mm or more being used,
wherein the adhesive material has a surface A in contact with the peel tape and a surface B in contact with the wafer,
P₁ is peel strength at the surface A when measured by keeping the peel tape at 90° with respect to the adhesive material, and
P₂ is peel strength at the surface B when measured by keeping the adhesive material at 90° with respect to a polyimide-coated wafer.

5. The peeling method according to claim 4,
wherein a layer having the surface A of the adhesive material contains a silicone-based adhesive component or a silicone release agent.

6. The peeling method according to claim 4 or 5,
wherein the adhesive material includes at least a wafer-side adhesive layer, a base film, and a peel tape-side adhesive layer.

7. An adhesive material used in the wafer production method or the peeling method according to any one of claims 1 to 6,
wherein P₂ is 0.5 N/25 mm or more.

8. A peel tape used in the wafer production method or the peeling method according to any one of claims 1 to 6,
wherein the peel tape has at least a base film and an adhesive layer, and contains a silicone-based adhesive in the adhesive layer.

9. The peel tape according to claim 8,
wherein the base film of the peel tape includes at least one of polyimide, polyester, or a fluororesin.
